# EUROPÄISCHE PATENTSCHRIFT

(11) **EP 2 103 373 B1**
(45) Veröffentlichungstag und Bekanntmachung des Hinweises auf die Patenterteilung: **14.09.2011**
(21) Anmeldenummer: 08154725.9
(22) Anmeldetag: 17.04.2008
(51) Int. Cl.: B23K 1/002, H01L 31/18, H05K 3/34

(54) **Löteinrichtung zum Verbinden von Solarzellen**
Welding device for connecting solar cells
Dispositif de soudure destiné à relier des cellules solaires

(30) Priorität: 20.03.2008 US 38161
(43) Veröffentlichungstag der Anmeldung: 23.09.2009
(73) Patentinhaber: Komax Holding AG, 6036 Dierikon (CH)
(72) Erfinder: Dingle, Brad M., Red Lion,, PA 17356 (US); Micciche, Brian S., Wrightsville,, PA 17368 (US); Sidelinger, Shawn M., York,, PA 17408 (US); Correll, Thomas R., Harrisburg,, PA 17111 (US); Neidert, Kenneth A., Lewisberry,, PA 17339 (US)
(74) Vertreter: Blöchle, Hans

(56) Entgegenhaltungen:
- EP-A- 0 449 790
- EP-A- 1 355 346
- EP-A- 1 748 495
- WO-A-80/02662
- WO-A-2008/151592
- DE-U1- 20 311 931
- JP-A- 10 302 956
- JP-A- 2000 068 043
- US-A- 4 685 608

## Beschreibung

Die Erfindung betrifft eine Löteinrichtung zum Verbinden von Solarzellen, wobei eine auf dem Induktionsprinzip arbeitende Wärmequelle mit Lötmittel versehene Leiterbahnen der Solarzellen mit elektrischen Leitern verbindet gemäss der Definition des unabhängigen Patentanspruchs.

Aus der Schrift EP 1 748 495 A1 ist eine Löteinrichtung zum elektrischen Verbinden von mehreren Solarzellen bekannt geworden, wobei an der Oberfläche der Zellen Leiterbahnen vorgesehen sind, die mit einem elektrisch leitenden Band belegbar sind und das Band mittels einer Wärmequelle mit den Leiterbahnen elektrisch verbindbar ist, wobei die Wärmequelle mittels induktiver Erwärmung Leiterbahnen und Band aufheizt und ein Lötmittel schmelzt, welches das Band mit den Leiterbahnen verbindet.

Das Dokument WO 80/02662 A betrifft eine Vorrichtung zum Kontaktieren der Leiterbahnen von Leiterplatten mit Kontaktstiften, die in Durchkontaktierungen der Leiterplatten sitzen. Zu diesem Zweck wird eine U-förmige Induktionsschleife eingesetzt, die von einem Hochfrequenzgenerator angetrieben wird. Es geht nicht um Solarzellen oder um das Anbringen von elektrischen Leitern auf den Leiterbahnen solcher Solarzellen.

Das Dokument US-4 685 608 betrifft eine Vorrichtung zum berührungslosen Schmelzen von Lötmittel und zum Herstellen entsprechender Lötverbindungen bei Solarzellen. Es geht insbesondere um das Beseitigen von Nachteilen, die mit dem Infraroterhitzen von Lötstellen verbunden sind. Es wird daher eine Kombination aus einem Induktionsheizmittel und einem Hitzeempfänger eingesetzt. Es geht hier also um ein indirektes Erhitzen mittels eines Hitzeempfängers, der Wärme abstrahlt. Die Erwärmung soll möglichst gleichmässig sein.

Das Dokument DE 20311931 betrifft eine Vorrichtung zum berührungslosen Schmelzen von Lötmittel und zum Herstellen entsprechender Lötverbindungen bei Solarzellen. Es kommt eine Kombination aus einem Induktor und einer Andruckplatte zum Einsatz, wobei die Andruckplatte zwischen dem Induktor und der zu lötenden Stelle sitzt. Damit die Andruckplatte keinen Kurzschluss des Induktors hervorruft, muss sie aus elektrisch nicht leitfähigem Material bestehen.

Das Dokument JP 10302956 betrifft eine Vorrichtung zum berührungslosen Schmelzen von Lötmittel und zum Herstellen entsprechender Lötverbindungen, wobei zwei einander gegenüberliegende Induktionschleifen zum Einsatz kommen, deren Form an einen wärmezubehandelnden nichtlinearen Leiter angepasst ist.

Das Dokument EP 1355346 betrifft eine vorrichtung zur Temperaturbehandlung von Halbleiterbauteilen. Es geht speziell um das lokale oder kontrollierte thermische Behandeln von Halbleiterschichten oder Bereichen. In EP 1355346 geht es schon alleine aufgrund der relativ niedrigen Temperaturen nicht um das Herstellen von Lötverbindungen.

Das Dokument EP 449790 betrifft eine Vorrichtung zum induktiven Löten von Kontakten an den Kanten von Hybridschaltungen und Leiterplatten. Es kommt eine zweiarmige Induktionschleife zum Einsatz, die im Zusammenwirken einen magnetischen Schmelzpunkt entlang einer Kante definiert.

Das Dokument JP 2000068043 betrifft eine Vorrichtung zum berührungslosen Induktionserhitzen eines konischen Körpers.

Das Dokument WO 2000/08151592 betrifft eine Vorrichtung zum induktiven Erwärmen von metallischen Bauelementen, wie z.B. Gasturbinen. Ziel ist es, eine gleichmässige Erwärmung der metallischen Bauteile zu erreichen. WO 2000/08151592 setzt auf den Einsatz von zwei Induktionsspulen, die einander gegenüber stehen.

Hier will die Erfindung Abhilfe schaffen. Die Erfindung, wie sie in Anspruch 1 gekennzeichnet ist, löst die Aufgabe, eine Löteinrichtung zu schaffen, die energiesparsam Lötverbindungen auf dem Induktionsprinzip herstellt.

Vorteilhafte Weiterbildungen der Erfindung sind in den abhängigen Patentansprüchen angegeben.

Die durch die Erfindung erreichten Vorteile sind im wesentlichen darin zu sehen, dass die Löteinrichtung mit kleinem Energieaufwand Lötverbindungen zwischen elektrischen Leitern herstellt. Die dazu notwendige Wärme wird mittels Induktorschleife erzeugt, wobei ein in der Induktorschleife fliessender, hochfrequenter Strom ein sich zeitlich änderndes Magnetfeld erzeugt, das in den zu verbindenden Leitern und im Lötmittel Wirbelströme (eddy current) verursacht, die wiederum die Leiter aufheizen und das Lötmittel schmelzen. Bei stromloser Induktorschleife kühlen sich Leiter und Lötmittel ab, wobei die Leiter mittels des Lötmittels verbunden werden. Der für die Erzeugung des Stromes in der Induktorschleife notwendige Hochfrequenzgenerator kann leistungsmässig kleiner dimensioniert werden und somit kostengünstiger hergestellt werden.

Durch die spezifische Formgebung der Induktorschleife kann das Magnetfeld und somit die Stromaufnahme der Induktorschleife, bzw. die Leistung des Hochfrequenzgenerators optimiert werden. Mit der erfindungsgemässen Induktorschleife kann bei gleicher Länge der Induktorschleife wie bisher der Hochfrequenzgenerator leistungsmässig auf einen Drittel reduziert werden oder bei gleicher Leistung des Hochfrequenzgenerators wie bisher die Länge der Induktorschleife verdreifacht werden. Die U-förmige Induktorschleife mit wellenförmigen Schenkeln erzeugt an den Verengungen ein schwächeres Magnetfeld und an den Aufweitungen ein stärkeres Magnetfeld wodurch eigentliche Lötzonen mit günstiger Wärmeverteilung gebildet werden. Im Zentrum einer jeden Aufweitung können zudem die miteinander zu verbindenden Leiter mittels eines magnetfeldneutralen und elektrisch isolierenden Niederhalters festgehalten werden. Auch kann die wirksame Länge der erfindungsgemässen Induktorschleife an die Länge der herzustellenden Lötverbindung einfach angepasst werden. Dazu wird an der entsprechenden Aufweitung ein elektrischer Kurzschluss beispielsweise durch manuelles oder maschinelles Einsetzen eines Bolzens oder einer Schraube erzeugt.

Anhand der beiliegenden Figuren wird die vorliegende Erfindung näher erläutert.

Es zeigen:
Fig. 1
   mehrere elektrisch zu einem Zellenband verbundene Solarzellen,
Fig. 2
   ein Lötkopf mit Induktorschleifen,
Fig. 3
   eine Induktorschleife mit Niederhaltern,
Fig. 4 und Fig. 5
   eine in der wirksamen Länge einstellbare Induktorschleife
Fig. 5a
   eine Ausführungsvariante der Induktorschleife und
Fig. 6
   Einzelheiten der Induktorschleife.

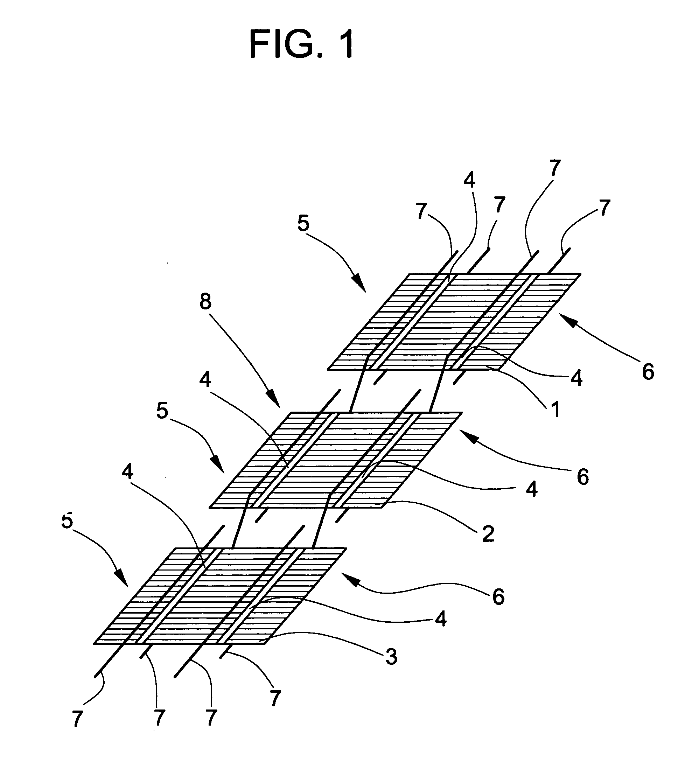

Fig. 1 zeigt eine erste Solarzelle 1, eine zweite Solarzelle 2 und eine dritte Solarzelle 3. Die Solarzellen 1,2,3 werden auch photovoltaische Zellen genannt und wandeln die im Licht enthaltene Strahlungsenergie in elektrische Energie um. Die in der Einzelzelle erzeugte Spannung steht zwischen Leiterbahnen 4 der Zellenoberseite 5 und in der Fig. 1 nicht sichtbaren Leiterbahnen der Zellenunterseite 6 an. Werden die Leiterbahnen 4 der Zellenoberseite 5 und die Leiterbahnen der Zellenunterseite 6 an eine elektrische Last als Verbraucher, beispielsweise ein ohmscher Widerstand oder eine Batterie angeschlossen, fliesst ein elektrischer Strom und die von der Solarzelle erzeugte elektrische Energie wird in der Last verbraucht bzw. in der Batterie gespeichert. Mehrere Solarzellen werden zu einem Band (string) elektrisch zusammengeschaltet. Mehrere Bänder ergeben ein Modul, auch Panel genannt. Die Solarzellen werden an den Leiterbahnen 4 der Zellenoberseite 5 und an den Leiterbahnen der Zellenunterseite 6 in Reihe geschaltet. Dabei addiert sich die Spannung der Einzelzelle und es können dünnere Leiter 7 für die Zusammenschaltung verwendet werden.

In Fig. 1 sind die erste Solarzelle 1, die zweite Solarzelle 2 und die dritte Solarzelle 3 zu einem Zellenband 8 elektrisch zusammengeschaltet. Ein Leiter 7 verbindet eine Leiterbahn 4 der Zellenoberseite 5 der ersten Solarzelle 1 mit der Leiterbahn der Zellenunterseite 6 der zweiten Solarzelle 2. Ein Leiter 7 verbindet eine Leiterbahn 4 der Zellenoberseite 5 der zweiten Solarzelle 2 mit der Leiterbahn der Zellenunterseite 6 der dritten Solarzelle 3.

Die Verbindung zwischen der Leiterbahn 4 und dem Leiter 7 wird mittels Lötvorgang hergestellt, wobei eine Wärmequelle die mit Lötmittel versehene Leiterbahn 4 und den Leiter 7 erwärmt und das Lötmittel, beispielsweise ein Weichlot schmelzt, wobei das flüssige Lötmittel die Leiterbahn 4 und den Leiter 7 benetzt. Nach der Wärmeeinwirkung entsteht eine feste, elektrisch leitende Verbindung zwischen der Leiterbahn 4 und dem Leiter 7.

Zur Herstellung der Lötverbindung kommen unterschiedliche Arten der Wärmeerzeugung in Frage. Besonders vorteilhaft ist, wie oben erwähnt, eine auf dem Induktionsprinzip arbeitende Wärmequelle, wobei ein Hochfrequenzgenerator in einer Induktorschleife einen hochfrequenten Strom beispielsweise mit einer Frequenz von 800 kHz bis 900 kHz erzeugt, der ein hochfrequentes Magnetfeld bewirkt.

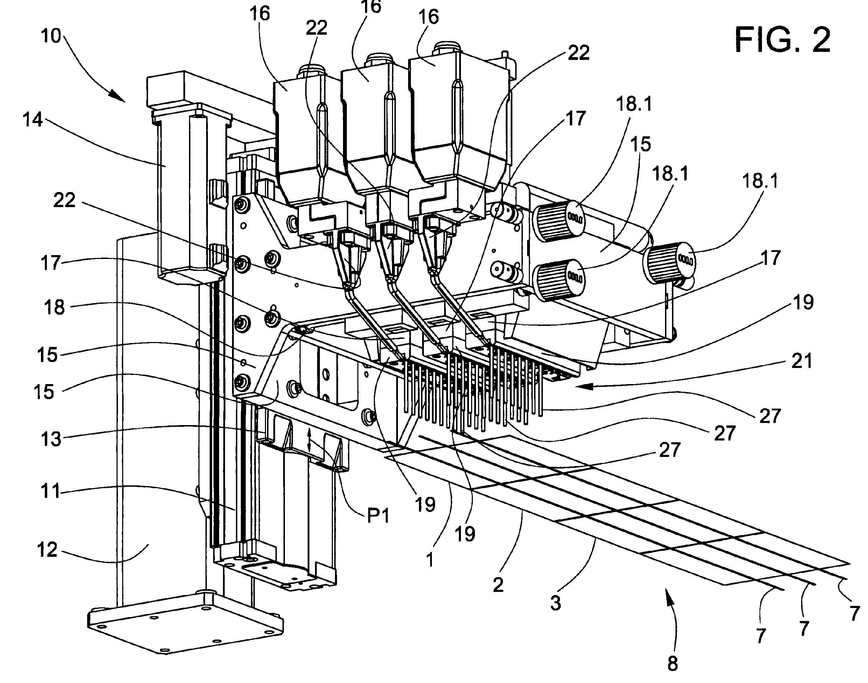

Fig. 2 zeigt einen Lötkopf 10 ausgerüstet mit drei Induktorschleifen 21. Eine Linearführung 11 ist an einem Ständer 12 angeordnet, wobei die Linearführung 11 der Führung eines Schlittens 13 dient, der mittels eines Motors 14 auf und ab, wie mit einem Pfeil P1 symbolisiert, bewegbar ist. Der Schlitten 13 dient als Träger für ein Gehäuse 15, an dem Anschlussblöcke 16, Führungsblöcke 17, Einstellspindeln 18 für die Induktorschleifen 21 und Niederhalter 27 angeordnet sind. Je Induktorschleife 21 ist eine Einstellspindel 18 vorgesehen, mittels der die Lage der Induktorschleife 21 und der Niederhalter 27 manuell mittels einer Einstellmutter 18.1 auf die entsprechende Leiterbahn 4 der Solarzelle ausrichtbar ist. Der Schleifenteil 24 ist in eine am Führungsblock 17 angeordnete Platte 19, beispielsweise aus Kunststoff, eingelegt. Jeder Niederhalter 27 ist in einer vertikalen Bohrung 17.1 im Führungsblock 17 frei beweglich. Beim Absenken des Lötkopfes 10 in Richtung Solarzelle 1,2,3 stehen die Niederhalter 27 auf dem Leiter 7 auf und drücken den Leiter 7 durch ihr Eigengewicht auf die Leiterbahn 4.

Fig. 2 zeigt Solarzellen mit drei parallelen Leiterbahnen 4. Mit dem gezeigten Lötkopf 10 können die drei Leiterbahnen 4 auf ihrer gesamten zellenlänge mittels der drei Induktorschleifen 21 gleichzeitig verlötet werden.

Falls Solarzellen mit zwei Leiterbahnen 4 bearbeitet bzw. verlötet werden, wird ein Anschlussblock 16, ein Führungsblock 17 mit Induktorschleife 21 und Niederhalter 27 entfernt. Für Solarzellen mit mehr als drei Leiterbahnen 4 kann der Lötkopf 10 auch grösser gebaut sein als gezeigt und mehr als drei induktorschleifen 21 aufweisen.

Der Anschlussblock 16 dient als Träger für die Induktorschleife 21 und umfasst einen Wasseranschluss, einen elektrischen Anschluss und den Hochfrequenzgenerator zur Erzeugung des hochfrequenten Stromes in der Induktorschleife 21.

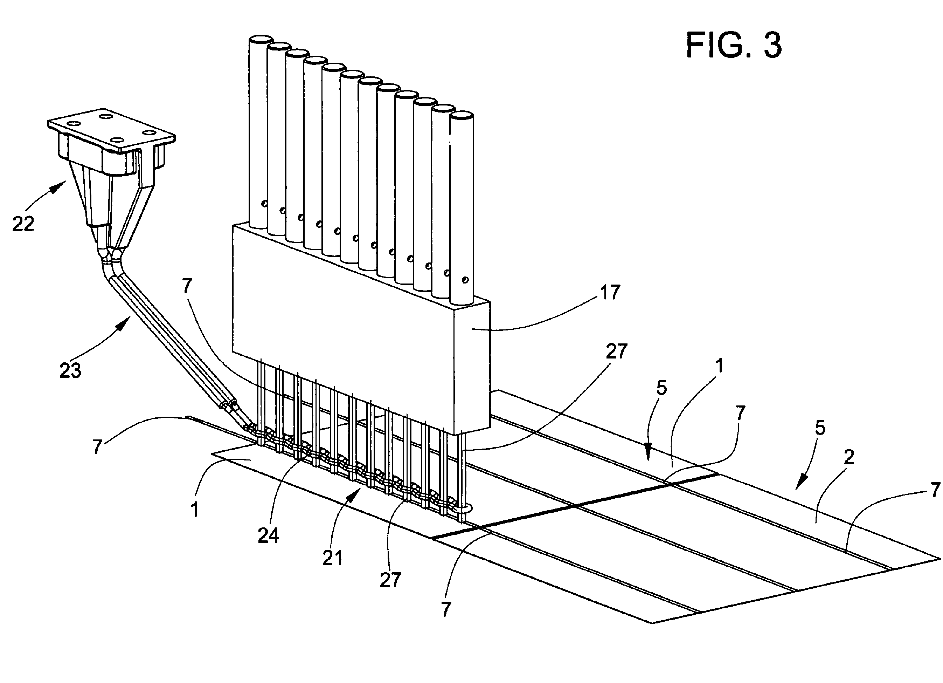

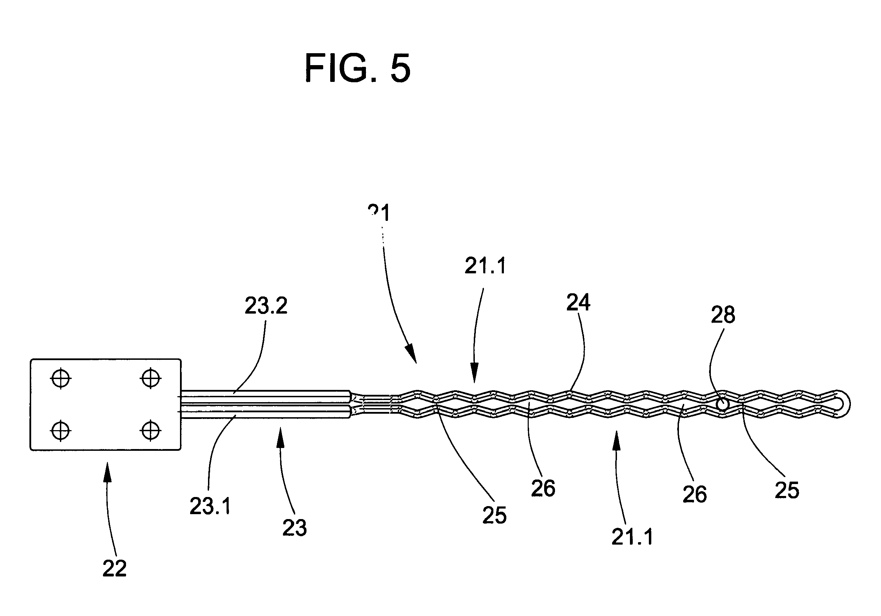

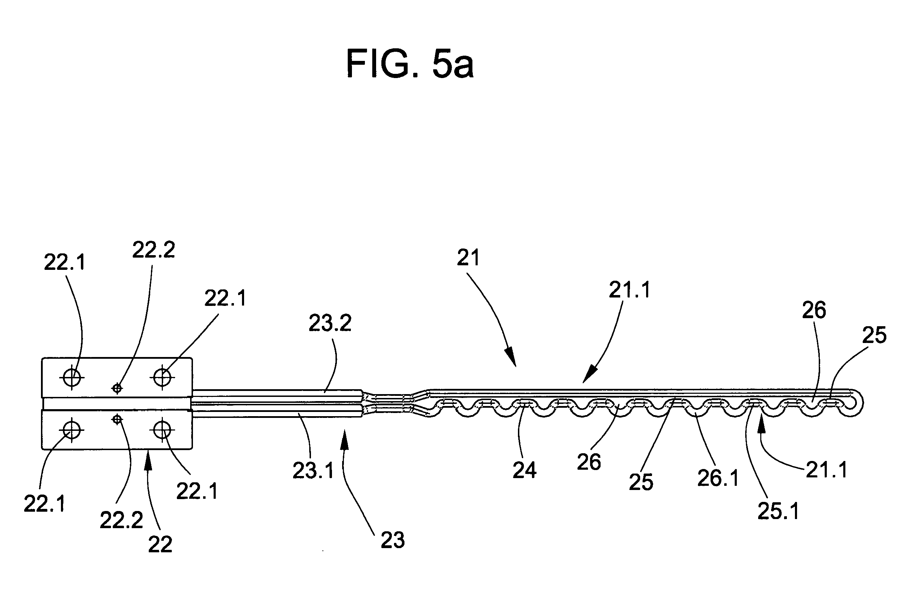

Fig. 3 zeigt eine erfindungsgemässe, am Lötkopf 10 angeordnete Induktorschleife 21 ohne Platte 19. Die Induktorschleife 21 besteht aus einem Anschlussstück 22, einem Zuführteil 23 und aus einem U-förmigen Schleifenteil 24, wobei mindestens ein Schenkel des Us gewellt ist. Zuführteil 22 und Schleifenteil 23 sind als Hohlleiter ausgebildet und werden mit Kühlmittel, beispielsweise Wasser durchströmt. Der Zuführteil 23 besteht aus zwei nahe beieinander liegenden Rohren 23.1, 23.2, die das Kühlmittel dem Schleifenteil 24 zuführen und vom Schleifenteil 24 abführen. Der Schleifenteil 24 besteht aus einem zu einer U-Form geformten Rohr mit zwei Schenkeln 21.1 und kommt der Form einer Haarnadel nahe. Die freien Enden des Rohrs sind mit den Rohren des Zuführteils 23 verbunden. Die Rohre des Zuführteils 23 und das Rohr des Schleifenteils 24 sind aus elektrisch leitendem Material wie beispielsweise Kupfer. Das U-förmige Rohr weist, wie in Fig. 5, 5a mit Bezugszeichen versehen, Verengungen 25 und Aufweitungen 26 auf. Die Verengungen 25 und die Aufweitungen 26 dienen, wie weiter oben dargestellt, der Optimierung der Wärmeentwicklung in der Lötzone und somit auch der Energieeinsparung. Jede Aufweitung 26 bietet Zugang zur Lötstelle für einen magnetfeldneutralen Niederhalter 27 beispielsweise aus Keramik, der den Leiter 7 auf die Leiterbahn 4 presst. Mit der in Fig. 3 gezeigten Induktorschleife 21 kann die gesamte Länge der Leiterbahn 4 der Zellenoberseite 5 einer Solarzelle 1, 2, 3 in einem Lötvorgang mit dem Leiter 7 verlötet werden. Das Magnetfeld der Induktorschleife 21 bzw. die Wirbelströme in der Leiterbahn 4 und im Leiter 7 vermögen auch gleichzeitig die Leiterbahn und den Leiter und das Lötmittel der Zellenunterseite 6 zu erwärmen bzw. zu schmelzen und eine Lötverbindung zwischen der Leiterbahn 4 und dem Leiter 7 herzustellen.

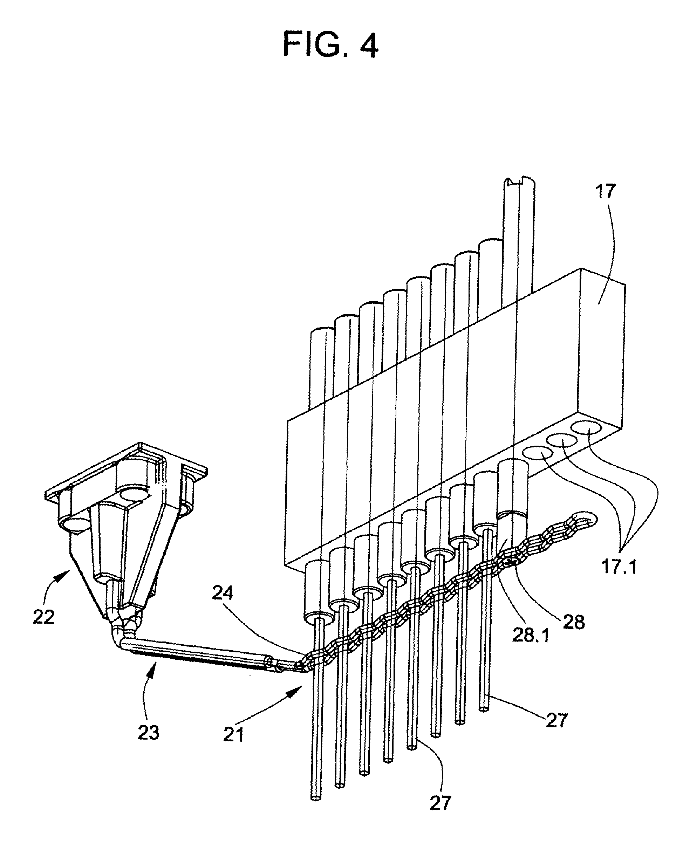

Fig. 4 und Fig. 5 zeigen eine in der wirksamen Länge einstellbare Induktorschleife 21. Die Abmessungen des Schleifenteils 24 entsprechen den Abmessungen des Schleifenteils 24 der Fig. 3. Je nach Bedarf bzw. je nach Grösse der zu verlötenden Solarzelle kann die wirksame Länge verkleinert werden. Eine in eine Ausweitung 26 eingesetzte Schraube 28 oder ein in eine Ausweitung 26 eingesetzter Bolzen 28 schliesst den Schleifenteil 24 kurz. Der hochfrequente Strom kann vom Hochfrequenzgenerator nur bis zur Schraube 28 bzw. Bolzen fliessen und ein Magnetfeld erzeugen. Die Schraube 28 bzw. der Bolzen kann mit dem Lötkopf lösbar verbunden sein und manuell oder maschinell einsetzbar sein. Die überzähligen Niederhalter 27 sind entfernt worden oder in einer höheren Lage fixiert worden und in die der Aufweitung 26 mit der Schraube 28 entsprechende Bohrung 17.1 ein Gewindebolzen 28.1 für die Schraube 28 eingesetzt worden.

Die Form der Aufweitungen 26 und der Verengungen 25 ist auch fertigungstechnisch bedingt. Für die Optimierung der Leistungsaufnahme ist vorwiegend der abschnittweise verkleinerte und vergrösserte Rohrabstand entscheidend. Die Biegeradien der Aufweitungen 26 und Verengungen 25 sind im Beispiel der Fig. 5 gross gewählt worden, damit der Schleifenteil 24 aus einem Rohr, bzw. einstückig in einem Biegeverfahren hergestellt werden kann. Falls eine Formgebung mit kleinen Biegeradien, beispielsweise eine Zick-Zack Form, gewählt wird, muss der Schleifenteil 24 aus Einzelteilen für die Aufweitungen 26 und Verengungen 25 zusammengefügt werden.

Fig. 5a zeigt den Schleifenteil 24 mit einer Formgebung, die von den Biegeradien her gesehen noch mit einem Biegeverfahren herstellbar ist. Das Rohr, bzw. der eine Schenkel 21.1 des U-förmigen Schleifenteils 24 ist gerade ausgeführt und der andere Schenkel 21.1 des Schleifenteils 24 ist wellenförmig mit Aufweitungen 26 und Verengungen 25 ausgeführt. Für die Aufweitungen 26 ist ein kreisbogenförmiger Abschnitt 26.1 und für die Verengungen 25 ist ein gerader Abschnitt 25.1 vorgesehen, wobei in die Aufweitungen 26 die Niederhalter 27 passen.

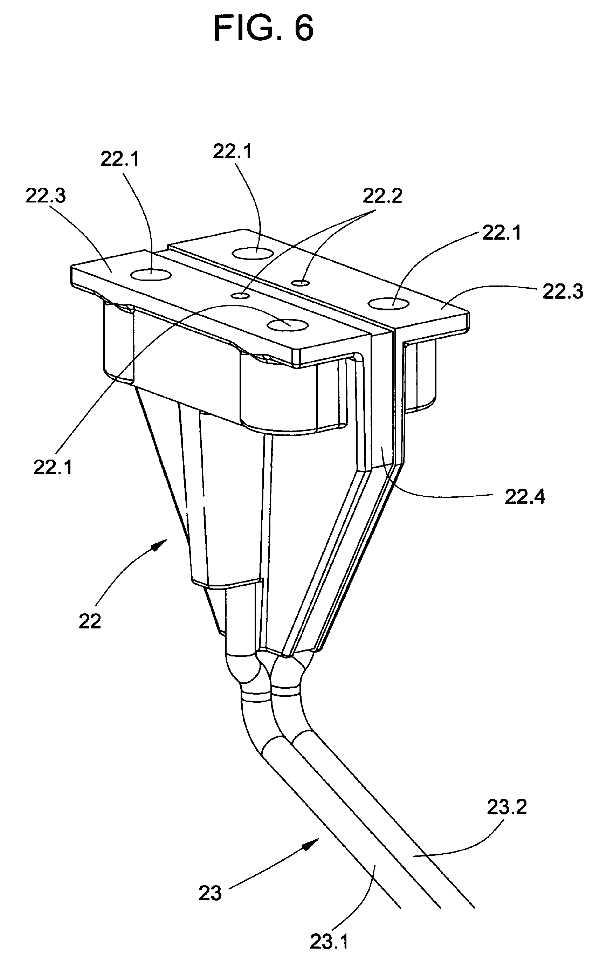

Fig. 6 zeigt Einzelheiten des Anschlussstückes 22 der Induktorschleife 21. Das Anschlussstück 22 wird mittels Bohrungen 22.1 durchdringenden Schrauben mit dem Anschlussblock 16 lösbar verbunden. Dabei wird auch der Wasseranschluss 22.2 mit dem Anschlussblock 16 verbunden und mittels eines nicht dargestellten, anschlussblockseitigen O-Ringes abgedichtet. Der Kühlmittelkreislauf zur Kühlung des Schleifenteils 24 ist damit geschlossen. Elektrisch wird das Anschlussstück 22 mittels Kontaktflächen 22.3 an den Anschlussblock 16 angeschlossen, wobei die Kontaktflächen 22.3 mittels einer Isolationsplatte 22.4 elektrisch getrennt sind.

## Patentansprüche

1. Löteinrichtung zum Verbinden von Solarzellen (1,2,3), wobei eine auf dem Induktionsprinzip arbeitende Wärmequelle mit Lötmittel versehene Leiterbahnen (4) der Solarzellen (1,2,3) mit elektrischen Leitern (7) verbindet, die Wärmequelle einen Hochfrequenzgenerator und eine Induktorschleife (21) aufweist, in der ein hochfrequenter Strom des Hochfrequenzgenerators ein hochfrequentes Magnetfeld bewirkt und dieses in der Leiterbahn (4) und in dem entlang der Leiterbahn (4) angeordneten elektrischen Leiter (7) Wirbelströme induziert, die die für den Lötvorgang notwendige Wärme erzeugen, und wobei die Löteinrichtung einen Niederhalter umfasst,
**dadurch gekennzeichnet,**
**dass** die Induktorschleife (21) U-förmig ausgebildet ist, wobei mindestens ein Schenkel (21.1) des Us wellenförmig so geformt ist, dass die Induktorschleife (21) Verengungen (25) und Aufweitungen (26) umfasst, und dass die Verengungen (25) und die Aufweitungen (26) der Optimierung der Wärmeentwicklung in einer Lötzone und somit auch der Energieeinsparung dienen, und dass es sich bei dem Niederhalter um einen magnetfeldneutralen Niederhalter (27) handelt und jede Aufweitung (26) Zugang zu einer Lötstelle für den magnetfeldneutralen Niederhalter (27) bietet.

2. Löteinrichtung nach Anspruch 1,
**dadurch gekennzeichnet,**
**dass** die Aufweitungen (26) und Verengungen (25) der energetischen Optimierung des hochfrequenten Magnetfeldes und des energiesparsamen Betriebes des Hochfrequenzgenerators dienen.

3. Löteinrichtung nach einem der Ansprüche 1 oder 2,
**dadurch gekennzeichnet,**
**dass** die Induktorschleife (21) aus einem Rohr gebildet ist, in dem Kühlmittel fliesst.

4. Löteinrichtung nach einem der Ansprüche 1 bis 3,
**dadurch gekennzeichnet,**
**dass** die wirksame Länge der Induktorschleife (21) einstellbar ist.

5. Löteinrichtung nach Anspruch 4,
**dadurch gekennzeichnet,**
**dass** eine Schraube (28) oder ein Bolzen (28) in einer Aufweitung (26) der Induktorschleife (21) anbringbar ist, wobei die Schraube (28) bzw. der Bolzen (28) die Induktorschleife (21) an der Stelle elektrisch kurzschliesst.

6. Löteinrichtung nach einem der vorhergehenden Ansprüche,
**dadurch gekennzeichnet,**
**dass** je Aufweitung (26) ein magnetfeldneutraler Niederhalter (27) vorgesehen ist, der die Aufweitung (26) durchdringt und den Leiter (7) auf die Leiterbahn (4) presst.

7. Löteinrichtung nach einem der Ansprüche 1 bis 6,
**dadurch gekennzeichnet,**
**dass** ein Lötkopf (10) mit an der Zahl gleich vielen Induktorschleifen (21) wie mit den Leitern (7) zu verbindenden Leiterbahnen (4) der Solarzellen (1,2,3) vorgesehen ist, wobei alle Leiterbahnen (4) einer Solarzelle mit den Leitern (7) gleichzeitig und auf der gesamten Länge verlötet werden.

## Claims

1. Soldering device for connecting solar cells (1, 2, 3) wherein a heat source that operates on the induction principle connects conductive tracks (4) of the solar cells (1, 2, 3) that are provided with solder compound with electric conductors (7), the heat source has a high-frequency generator and an inductor loop (21) in which a high-frequency current of the high-frequency generator gives rise to a high-frequency magnetic field, and the latter induces in the conductive track (4) and in the electric conductor (7) that is arranged along the conductive track (4) eddy currents that generate the heat that is necessary for the soldering operation, and wherein the soldering device contains a pressure foot,
**characterized in that**
the induction loop (21) is embodied U-shaped, at least one arm (21.1) of the U being sinuously formed in such manner that the inductor loop (21) contains constrictions (25) and expansions (26) and that the constrictions (25) and the expansions (26) serve to optimize the heat evolution in a solder zone and hence also to save energy, and that the pressure foot is a magnetic-field-neutral pressure foot (27) and that each expansion (26) provides access to a solder point for the magnetic-field-neutral pressure foot (27).

2. Soldering device according to Claim 1,
**characterized in that**
the expansions (26) and constrictions (25) serve to energetically optimize the high-frequency magnetic field and the energetically economical operation of the high-frequency generator.

3. Soldering device according to one of claims 1 or 2,
**characterized in that**
the inductor loop (21) takes the form of a tube in which coolant flows.

4. Soldering device according to one of claims 1 to 4,
**characterized in that**
the effective length of the inductor loop (21) is settable.

5. Soldering device according to Claim 5,
**characterized in that**
a screw (28) or a bolt (28) can be inserted into an expansion (26) of the inductor loop (21), the screw (28) or the bolt (28) electrically short-circuiting the inductor loop (21) at that point.

6. Soldering device according to one of the foregoing claims,
**characterized in that**
provided for each expansion (26) is a magnetic-field-neutral pressure foot (27) which penetrates through the expansion (26) and presses the conductor (7) onto the conductive track (4).

7. Soldering device according to one of claims 1 to 6,
**characterized in that**
a soldering head (10) is provided with the same number of inductor loops (21) as the number of conductive tracks (4) of the solar cells (1, 2, 3) that are to be connected to the conductors (7), all conductive tracks (4) of a solar cell being soldered to the conductors (7) simultaneously and along the entire length.

## Revendications

1. Dispositif de soudage pour relier des cellules solaires (1, 2, 3), étant précisé qu'une source de chaleur fonctionnant selon le principe de l'induction relie des pistes conductrices (4), pourvues d'un agent à souder, des cellules solaires (1, 2, 3) à des conducteurs électriques (7), que la source de chaleur comporte un générateur haute fréquence et une boucle d'inducteur (21) dans laquelle un courant haute fréquence du générateur haute fréquence provoque un champ magnétique haute fréquence et celui-ci induit dans la piste conductrice (4) et dans le conducteur électrique (7) disposé le long de ladite piste conductrice (4) des courants de Foucault qui produisent la chaleur nécessaire pour l'opération de soudage, et étant précisé que le dispositif de soudage comprend un abaisseur,
**caractérisé en ce que** la boucle d'inducteur (21) a une forme en U, étant précisé qu'au moins une branche (21.1) du U a une forme ondulée telle que la boucle d'inducteur (21) comprend des parties rétrécies (25) et des parties élargies (26) et que les parties rétrécies (25) et les parties élargies (26) servent à optimiser le dégagement de chaleur dans une zone de soudage et aussi, de ce fait, à économiser de l'énergie, et que l'abaisseur est constitué par un abaisseur à champ magnétique neutre (27) et chaque partie élargie (26) donne accès à un point de soudage pour l'abaisseur à champ magnétique neutre (27).

2. Dispositif de soudage selon la revendication 1, **caractérisé en ce que** les parties élargies (26) et les parties rétrécies (25) servent à une optimisation énergétique du champ magnétique haute fréquence et du fonctionnement économe en énergie du générateur haute fréquence.

3. Dispositif de soudage selon l'une des revendications 1 ou 2, **caractérisé en ce que** la boucle d'inducteur (21) se compose d'un tube dans lequel coule un agent de refroidissement.

4. Dispositif de soudage selon l'une des revendications 1 à 3, **caractérisé en ce que** la longueur active de la boucle d'inducteur (21) est réglable.

5. Dispositif de soudage selon la revendication 4, **caractérisé en ce qu'**une vis (28) ou une tige (28) est apte à être installée dans une partie élargie (26) de la boucle d'inducteur (21), la vis (28) ou la tige (28) court-circuitant électriquement la boucle d'inducteur (21) à cet endroit.

6. Dispositif de soudage selon l'une des revendications précédentes, **caractérisé en ce qu'**il est prévu pour chaque partie élargie (26) un abaisseur à champ magnétique neutre (27) qui traverse ladite partie élargie (26) et presse le conducteur (7) sur la piste conductrice (4).

7. Dispositif de soudage selon l'une des revendications 1 à 6, **caractérisé en ce qu'**il est prévu une tête de soudage (10) avec un nombre de boucles d'inducteur (21) égal au nombre de pistes conductrices (4) des cellules solaires (1, 2, 3) à relier aux conducteurs (7), toutes les pistes conductrices (4) d'une même cellule solaire étant reliées par soudage aux conducteurs (7) en même temps et sur toute leur longueur.
